Europäisches Patentamt

European Patent Office

Office européen des brevets

(11) Publication number : **0 494 759 A1**

# (12) EUROPEAN PATENT APPLICATION

(21) Application number : **92300129.1**

(22) Date of filing : **08.01.92**

(51) Int. Cl.⁵ : **H05K 7/14**

(30) Priority : **09.01.91 GB 9100403**

(43) Date of publication of application :
**15.07.92 Bulletin 92/29**

(84) Designated Contracting States :
**BE DE DK ES FR GR IT LU NL PT SE**

(71) Applicant : **GPT LIMITED**
**New Century Park P.O. Box 53**
**Coventry, CV3 1HJ (GB)**

(72) Inventor : **Holguette, Peter Alan**
**Yaffle House, Water Tower Road**
**Broadstone, Dorset BH18 8LL (GB)**

(74) Representative : **Branfield, Henry Anthony**
**The General Electric Company plc Patent**
**Department(Wembley Office) Hirst Research**
**Centre East Lane**
**Wembley, Middlesex HA9 7PP (GB)**

(54) **Orthogonal interconnection.**

(57) A circuit board arrangement comprises two sets of orthogonally mounted printed circuit boards the sets being on opposite sides of a mid-plane board, which mid-plane board consists of a conductive sheet or printed circuit board wherein the mid-plane board does not include tracks for the distribution of signals to the boards.

Fig.2.

EP 0 494 759 A1

Designing a digital switching subsystem into a conventional shelf structure results in a complex multilayer backplane. For switches working at higher rates the backplane becomes even more complex due to the need to control crosstalk, propagation delays and signal integrity over the wider frequency spectrum.

In a conventional two-dimensional topology of printed circuit boards and a backplane used to interconnect switch planes, three problems arise;

a) The backplane is, of necessity, very complex.

b) Signal tracking is necessarily long and therefore inefficient.

c) Variable length tracks occur for different signal paths.

At higher signal speeds these problems would be compounded by system performance requirements in that signal speeds approaching 200 Mbit/s would require 'tailored stripline backplanes' to hold and maintain signal characteristic impedances, so as to avoid signal reflections, crosstalk and other losses. Taking all this into account, a backplane would be a very difficult and expensive item to lay out and manufacture for such a situation.

As the speed and complexity of switching networks increases, it will become increasingly important to keep interconnection paths as simple, uncrossed, and short as possible. This is very difficult with a two dimensional arrangement.

A three dimensional orthogonal topology achieves this and solves the problem elegantly since it removes several hundred critical tracks from the 'backplane', in which tracks exist in a two-dimensional topology. Capacitance loading effects of signalling tracks are also reduced to a minimum since interconnection lengths between cards may be kept at a constant 3-4 centimetres.

Clearly departures from a standard equipment practice configuration are undesirable. However, the orthogonal approach to interconnecting switching planes is an efficient and simple solution to complex interconnect topologies in both current and future products. Nevertheless, its implementation will raise a number of issues within hardware engineering such as dimensional accuracy (and repeatability), rigidity, connectors, equipment practice policy, testing, maintenance etc. It is believed that orthogonal topologies may be the only practical method of interconnection when bit rates of 2.4 Gbit/s and higher are used in future switching architectures.

According to the present invention there is provided two sets of orthogonally mounted printed circuit boards on opposite sides of a mid-plane board, the mid-plane board consisting of a conductive sheet or printed circuit board which does not include tracks for the distribution of signals. A central board in each orthogonal set provides means for distribution of signals and possibly power. Signal paths between the two sets of boards will be connected by connectors mounted through the mid-plane board. The connectors may be, for example, electrical or optical in form.

The invention will now be described, by way of example, with reference to the accompanying drawings, in which :-

Figure 1 is a schematic representation of an orthogonal array of printed circuit cards;

Figure 2 is a more detailed partial, exploded view of the arrary of Figure 1;

Figure 3 shows a detail of the connection through the mid-plane board of Figures 1 and 2;

Figure 4 shows a detail of the connection to the mid-plane board of Figures 1 and 2;

Figure 5 is a further detailed elevation of the array of Figure 1 showing one possible arrangement for the distribution of power and signals;

Figure 6 shows a partial view of a pair of boards of the types shown in Figure 1 using 'free-flight' optics for the connection of signals;

Figure 7 shows a similar arrangement to that shown in Figure 6 using a holographic lens.

As the name implies, orthogonal interconnect is approximately symmetrical in several planes. In a switching context PCB's connected edge-to-edge can be added or removed without effecting the overall orthogonal matrix.

In a fully populated switching unit there are say 18 Central Switching Modules (CSM's) and 32 Outer Switching Modules (OSM's). Each Module is normally configured on one card. Normally each duplicated core switching unit would be housed in a double shelf (interfaced to a double backplane). In such an orthogonal arrangement, each CSM card would address up to 32 OSM's and conversly each OSM card would address 18 CSM's. Each OSM card would receive either 8 bi-directional or 16 uni-directional fibre-optic, optical or coaxial interfaces at 194.4 Mbit/s.

In terms of switch growth, an orthogonal topology would simplify matters in that OSM's could be added to the Switching Module. Similarly if a half size switch was required (16 OSM's) a scaled down version of the CSM could be slotted in place of the 'full switch' version. The mid-plane would remain unchanged since its function is basically as a ground plane.

In the proposed orthogonal array, OSM's and CSM's would be assembled (and also disassembled) by plugging together cards via the mid-plane.

The mid-plane is the mid-dimension and therefore critical in an array such as this. It supports and aligns (via an appropriate super-structure) the interconnection exchanges at each of the horizontal card/vertical card intersections.

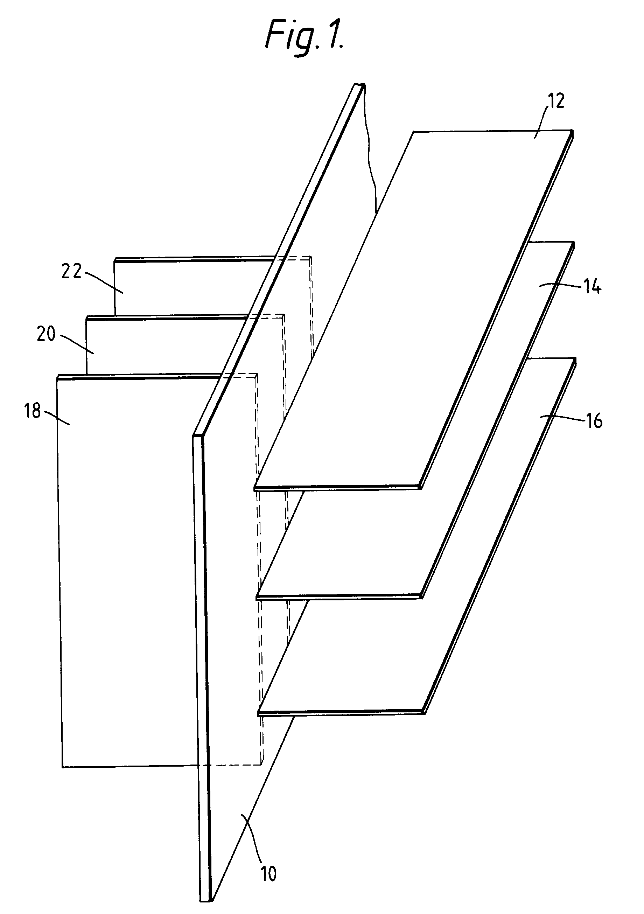

Referring to Figure 1 of the drawings, a mid-plane board 10 has two sets of orthogonally mounted cards 12, 14 and 16 and 18, 20 and 22 mounted on opposite sides thereof. The use of three cards in each set is by way of example, in practice many more cards may be used. The mid-plane board 10 is used mainly to provide EMI screening and physical support for the cards, 12, 14, 16, 18, 20 and 22 and is typically in the form of a conductive sheet or double-sided copper clad glass epoxy board of the type used for making printed circuits. The mid-plane board 10 may also provide power supply or mid-plane ground connections for the orthogonally mounted cards 12, 14, 16, 18, 20, 22 as these may be provided without seriously affecting the screening properties of the mid-plane board 10. However, signal connections are not included in connections made by tracks on the mid-plane board 10.

Dedicated distribution cards 14, 20 provide card-to-card interconnection by signals connected through the mid-plane board 10 without electrical contact therewith. Preferably the distributor card 14, 20 is the central card of a set so that signals, especially clock signals, are fanned out symmetrically to the switching cards 12, 16, 18 and 22.

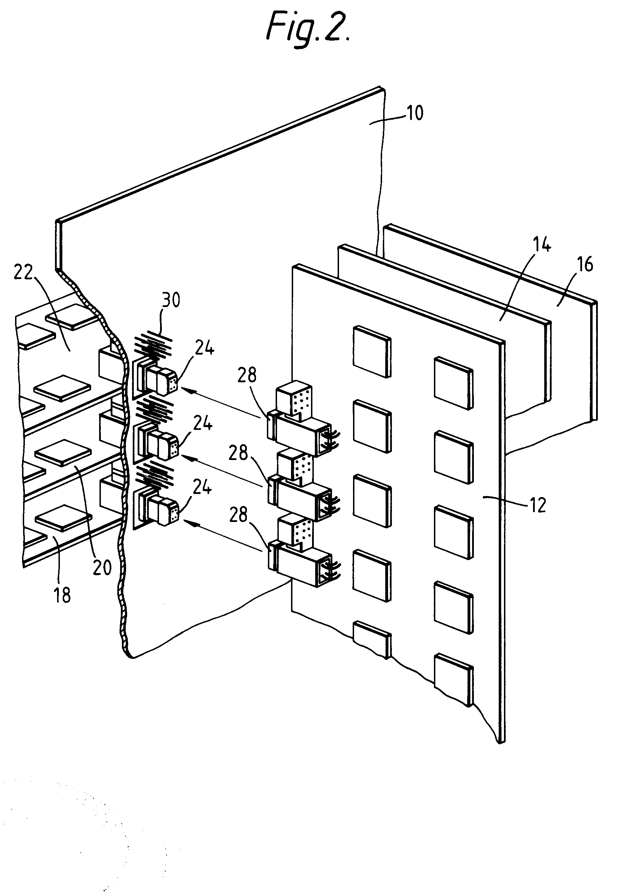

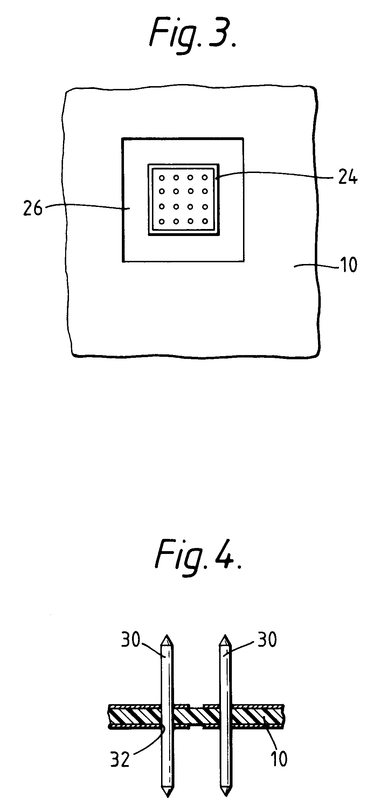

In Figures 2, 3 and 4 the connections are shown. Connectors 24 are fitted through copper-free windows 26 in the mid-plane board 10. Mating connectors 28 on the cards 2, 14, 18, 20 and 22 engage with the connectors 24.

Press-fit pins 30 inserted in plated-through holes 32 in the mid-plane board 10 provide contact with the mid-plane ground or power supply rails. Connectors 34 on the cards 12, 14, 16, 18, 20 and 22 engage the pins 30 and make the connections to the cards 12, 14, 16, 18, 20 and 22.

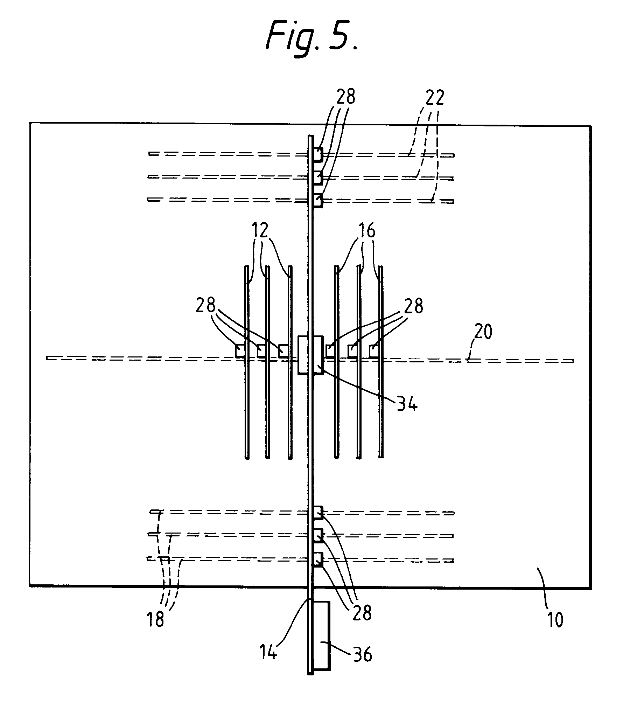

In Figure 5 there is shown a representation of a full set of switching cards 12 and 16, on the near side of the mid-plane board 10, and 18 and 22 on the far side of the mid-plane board 10. The corresponding connectors 28 on the cards 12, 16, 18 and 22 are also shown. Additionally, a connector 34 connects the near side distributor card 14 to the far side distributor card 20 and a connector 36 provides the external connections to the near side distributor card 14.

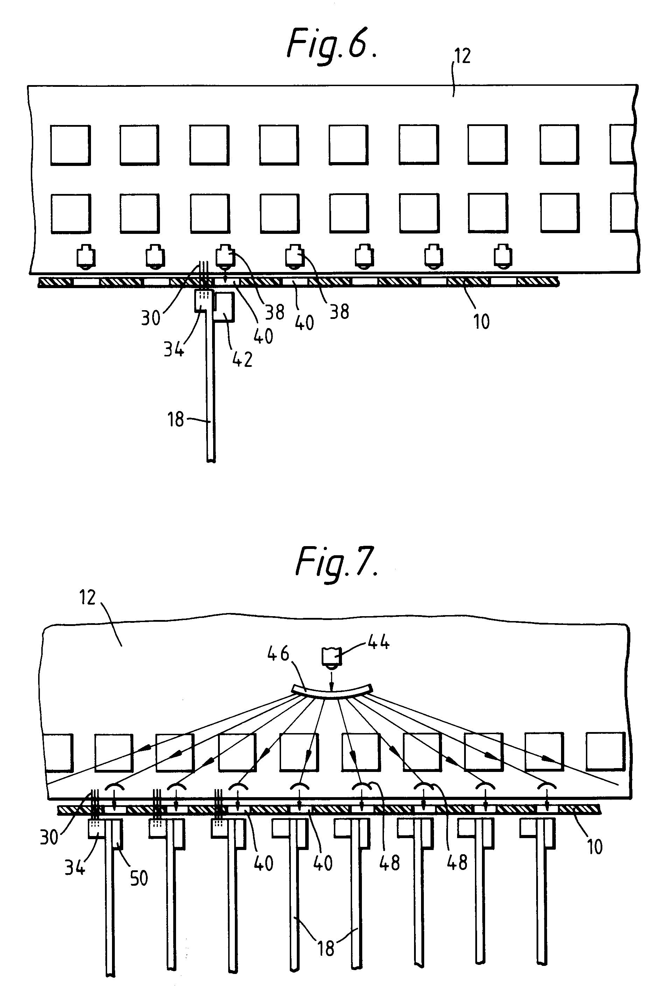

In Figure 6 a representative pair of orthogonal cards 12 and 18 are shown mounted on a mid-plane board 10. On the bottom edge of the card 12 are mounted transmitting light emitting diodes 38, opposite apertures 40 in the board 10. The light emitted by a diode 38 is focussed on a receiver PIN Field Effect Transistor 42 transmitting the signals from card 12 to card 18. Power and ground connections for the cards 12 and 18 are obtained through the pins 30 and mating connectors 34 are described above.

Alternatively, as shown in Figure 7, light from a laser source 44 on the card 12 is directed by a holographic lens 46 onto focussing lenses 48 and directed through apertures 40 in the mid-plane board 10 onto receivers 50 mounted on the card 18. Again power and ground connections for the cards 12 and 18 are obtained through the pins 30 and mating connectors 34.

## Claims

1. A circuit board arrangement comprising two sets of orthogonally mounted printed circuit boards the sets being on opposite sides of a mid-plane board, which mid-plane board consists of a conductive sheet or printed circuit board characterised in that the mid-plane board does not include tracks for the distribution of signals to the boards.

2. A circuit board arrangement as claimed in Claim 1, wherein a board in each orthogonal set provides means for distribution of signals to the remaining boards.

3. A circuit board arrangement as claimed in Claim 1 or Claim 2, wherein signal paths between the two sets of boards are made by connectors mounted through the mid-plane board.

4. A circuit board arrangement as claimed in Claim 3, wherein the connectors are optical connectors.

# Fig.1.

# Fig.2.

## Fig. 3.

## Fig. 4.

Fig. 5.

# Fig.6.

# Fig.7.

European Patent
Office

**EUROPEAN SEARCH REPORT**

Application Number

EP 92 30 0129

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 876 630 (P.DARA)<br>* column 1, line 15 - line 32 *<br>* column 2, line 40 - line 54 *<br>* column 3, line 9 - line 25 *<br>* column 3, line 46 - line 33; figure 1 *<br>--- | 1,3 | H05K7/14 |
| A | EP-A-0 220 677 (ALCATEL)<br>* page 1, line 3 - line 10 *<br>* page 5, line 3 - line 25 *<br>* page 7, line 32 - page 8, line 3 *<br>* page 8, line 21 - line 30; figures 1,2 *<br>--- | 1,3 | |
| A | US-A-4 472 765 (P.F.HUGHES)<br>* column 1, line 39 - line 52 *<br>* figure 3 *<br><br>----- | 1 | |
| | | | **TECHNICAL FIELDS SEARCHED (Int. Cl.5 )**<br><br>H05K<br>H01R |

The present search report has been drawn up for all claims

| Place of search | Date of completion of the search | Examiner |
|---|---|---|
| BERLIN | 18 MARCH 1992 | ALEXATOS G. |

EPO FORM 1503 03.82 (P0401)